# EUROPEAN PATENT SPECIFICATION

(11) **EP 0 526 992 B1**
(45) Date of publication and mention of the grant of the patent: **01.05.1996**
(21) Application number: 92306273.1
(22) Date of filing: 08.07.1992
(51) Int. Cl.: H01L 23/538

(54) **Multilayer carrier for mounting an integrated circuit and method of making the same**
Mehrschichtiger Träger für integrierte Schaltungen und Verfahren zu dessen Herstellung
Dispositif multicouche pour le montage de circuits intégrés et son procédé de fabrication

(30) Priority: 25.07.1991 US 735749
(43) Date of publication of application: 10.02.1993
(73) Proprietor: NCR INTERNATIONAL INC., Dayton, Ohio 45479 (US)
(72) Inventor: Hilbrink, John O., Cincinnati, OH 45242 (US)
(74) Representative: Robinson, Robert George

(56) References cited:
- EP-A- 0 232 533
- IBM TECHNICAL DISCLOSURE BULLETIN, vol. 30, no. 2, July 1987, New York US, pp. 772-773; "Multi-technology chip carrier"
- PATENT ABSTRACTS OF JAPAN vol. 14, no. 268 (E-939) 11 June 1990 ; & JP-A-20 83 946

## Description

The present invention relates to multilayer carriers for mounting integrated circuits.

The speed at which microprocessors can execute instructions has increased dramatically in recent years. The increase in speed has been so great that propagation delays in data travelling to and from the microprocessor chip have become a limitation on processor performance.

As an example, the 8080 microprocessor, which was introduced around 1973, commonly operated at a clock speed of 1 MegaHerz (MHz). Each instruction requires between 3 and 5 clock cycles, giving a resulting speed of approximately 200,000 to 300,000 instructions per second. In contrast, a processor of the '486 family, available in 1991, can have a clock rate of 50 MHz. A typical instruction requires about 2.5 clock cycles, resulting in a speed of about 20 million instructions per second. Plainly, this speed is about 100 times faster than that of the 8080 processor.

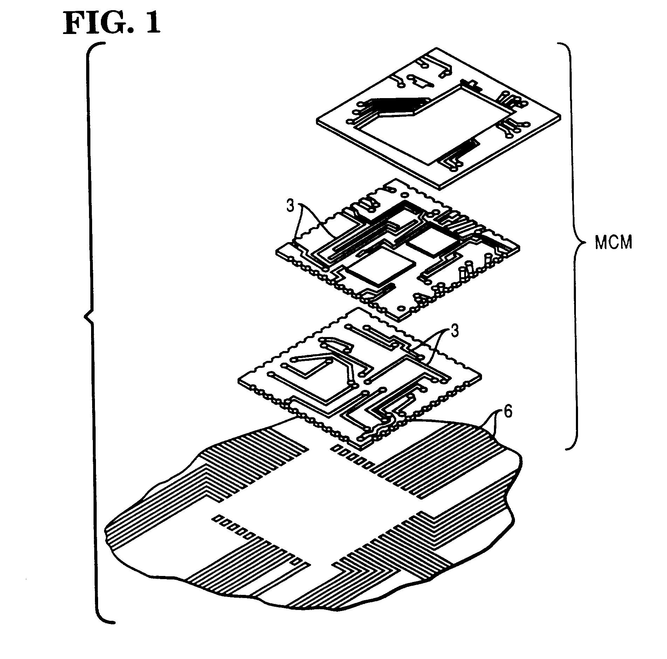

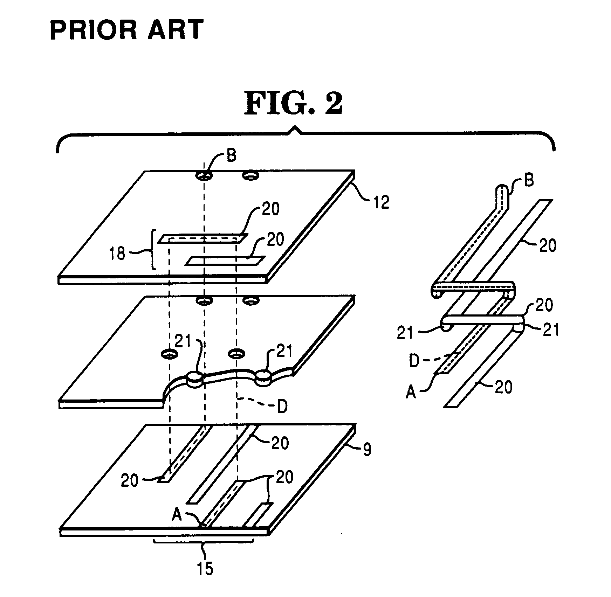

In order to reduce propagation delays between the microprocessor and associated memory components, developers have devised ways to pack large numbers of ICs onto small carriers. One such carrier is the Multi-Chip Module, or MCM, shown in Figure 1. The MCM is a multi-layered structure, in which conductors 3 interweave among themselves to interconnect between the ICs and external traces 6. The interweaving can be explained by reference to Figure 2. Different layers 9 and 12 carry different patterns 15 and 18 of conductors 20. When the layers are assembled, cross layer connections or vias 21 connect the patterns, and the assembly provides a 3-dimensional interwoven connection system, which allows any arbitrary point A to connect with any other arbitrary point B, as indicated by dashed path D.

Several types of MCM are in use. One type is constructed of multi-layered printed-circuit boards. The conductive patterns are printed using silk-screen techniques, and have a line width limit of about 0.005 inches (0.13mm). (The limit refers to a minimum width of lines: the narrowest line possible is 0.13 mm. Line width is inversely proportional to interconnect density. The lines are referred to as interconnects, and narrower lines allow more of them to be packed into a given space, thus increasing the density, measured in number of lines per square inch (6.452 x 10⁻⁴m).

With such a large line width, the density of lines is small, compared to that available in other approaches, as will be seen. However, the cost is relatively low. A single, completed pattern-bearing layer costs roughly 10 cents per square inch (6.452 x 10-⁴m). A 10-layer board would thus cost about $1.00 per square inch (6.452 x 10-⁴m).

A second type utilizes ceramic layers on which the patterns are printed by a silk-screen process. The line width is about 0.13mm. For single layers in the form of squares about 2 x 2 inches (25.086 x 10-⁴m) or smaller, the price is roughly $1.00 per square inch (6.452 x 10-⁴m). For larger sizes, the price increases significantly.

A third type, as described in IBM technical Disclosure Bulletin, vol 30, no.2, July 1987, pages 772-773, utilizes copper polyimide layers positioned on top of ceramic layers. The printing process is photolithography, which can provide a minimum line width of less than 1 mil (0.026mm). However, the present cost is roughly $32 per square inch (6.452 x 10-⁴m) for a four-layer unit.

A fourth type uses silicon layers, with photolithographic printing. The line width of less than 1 mil (0.026mm), and the cost is about $15 per layer, totalling about $60 for four layers.

A fifth type, as disclosed in Patent Abstracts of Japan, vol 14, no. 268, (E-939) 11 June 1990 & JP-A-20 83 946, details a multilayer film used to mount a chip and to connect the chip to a substrate. The film is formed of a first layer with the same coefficient of thermal expansion as the chip, a second layer with the same coefficient of thermal expansion as the substrate and a plurality of films with an intermediate coefficient of thermal expansion. An electrical connection is made between the chip and the substrate by pins passing through the multilayer film.

The cost estimates given above are approximate, and can vary greatly, depending on numerous factors, such as quantity purchased, previous dealings between parties, and complexity of the conductor patterns.

In these types of MCM, the cost increases as line width becomes smaller. Smaller line widths are required for higher IC densities. Consequently, as IC densities increase, these types of MCM will impose higher costs.

It is an object of the invention to provide an improved interconnection system for integrated circuits.

It is a further object of the invention to provide an interconnection system providing high IC density, yet with low cost.

According to one aspect of the present invention there is provided multilayer carrier for mounting an integrated circuit comprising a rigid printed circuit board, a multilayer structure mounted on said board and having a three dimensional network for electrical connection of at least one integrated circuit to be mounted on said structure, and electrical connection means for connecting electrical connection traces on said board to said network, said structure comprising a plurality of flexible sheets and said electrical connection means consisting of a plurality of pin members passing through said plurality of flexible sheets, characterized in that said traces are located on a first side of said board only, said structure is mounted on a second side of said board opposite said first side, and said pin members pass through said board.

According to another aspect of the present invention there is provided a method of forming a multilayer carrier for mounting an integrated circuit in which a multilayer structure comprising a plurality of flexible sheets, with a three-dimensional network for electrical connection of at least one integrated circuit to be mounted on said structure, is mounted on a rigid printed circuit board having electrical connection traces so as to connect said network to said traces, characterized in that said traces are located on a first side of said board only, and said structure is mounted on a second side of said board opposite said first side, wherein the connection between said network and said traces, is formed by passing a plurality of conductive pin members into said board and said structure so as to extend therethrough.

In one form of the invention, an MCM is stacked atop a PC board, such that conductive pads on the MCM are in registration with conductive traces on the PC board. Holes are positioned in both the PC board and the MCM so that pins may be inserted, each of which runs from a respective pad to a respective trace. The pins are then soldered to the pads and traces, providing both mechanical support and electrical connections. The MCM is constructed of multiple layers of flexible sheets, on which patterns of copper conductors have been formed. It should be understood that in the present specification and claims by a flexible sheet is meant a layer which is sufficiently flexible that it may be individually formed into a roll without suffering damage.

In a particularly advantageous form, the invention consists of a Multi-Chip Module consisting of (A) two layers of high-density interconnect (i.e., line widths of about 1 mil (0.025mm) or less) connecting the integrated circuits (ICs) together, and (B) two layers of conventional printed circuit boards which support the two layers of interconnect. The printed circuit boards distribute power to the ICs and also carry signals between the ICs and external sources. This form is significantly less expensive than the known approaches above, for a comparable interconnect density. That is, in the invention, the two layers of high-density interconnect have a final cost of about $1.00 per square inch (6.452 x 10-⁴m). The two layers of conventional PC board cost about $0.10 per square inch (6.452 x 10-⁴m), giving a total cost of $2.20 per square inch (6.452 x 10-⁴m). This cost is significantly less than that of copper polyimide layers over ceramic, costing about $32.00 per square inch (6.452 x 10-⁴m).

The invention is described further hereinafter, by way of example only, with reference to the accompanying drawings in which:-
Fig 1 illustrates a known Multi-Chip Module (MCM);
Fig 2 illustrates a 3-dimensional network in an MCM comprising two layers of conductive traces;
Fig. 3 illustrates one form of the present invention;
Fig. 4 is a top view of an interconnect medium according to an embodiment of the invention and carrying integrated circuits;
Fig. 5 is a cut-away perspective view of the interconnect medium of Fig. 4, mounted on a Printed Circuit (PC) board, as in Fig. 3;
Fig. 6 is a top view of four MCMs mounted on a common PC board according to an embodiment of the invention;
Fig. 7 is a bottom view of the PC board of Fig. 6;
Fig. 8 illustrates a sequence in which a drill bit drills a hole in an MCM abutted against a PC board according to an embodiment of the invention;
Fig. 9 illustrates how a stack of drill bits can be formed from a wire;
Fig. 9A illustrates the drilling of two holes in the rod of Fig. 9;
Fig. 9B illustrates the grinding of a notch in the rod of Fig. 9;
Fig. 10 illustrates a stack of drill bits drilling a hole in an MCM abutted to a PC board;
Fig. 11 illustrates breaking the stack of drill bits by bending at the notch of Fig. 9B;
Fig. 12 illustrates a jagged point which may be caused by the breaking illustrated in Fig. 11;
Fig. 13 illustrates a spade bit having cutting edges of larger diameter than the shank of the bit; and
Fig. 14 illustrates a sheet of material formed in a roll about a reference radial.

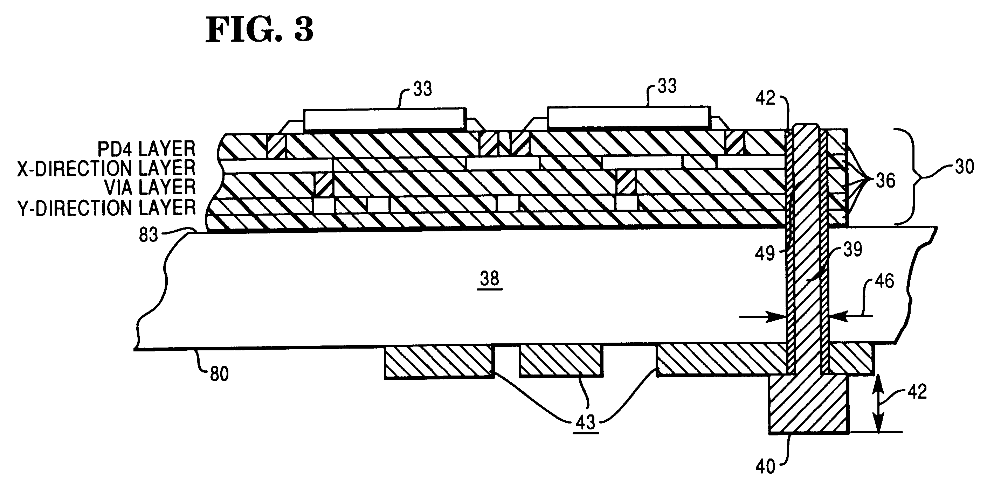

Fig. 3 shows one form of the invention. A Flexible Lamina stack 30 carries integrated circuits (ICs) 33. The term "flexible lamina" refers to the fact that the individual layers 36 are constructed of flexible dielectric sheets. The sheets can be a polyimide such as Mylar, 0.006 inches (0.152mm) thick. Mylar sheet is available from DuPont Corporation, located in Delaware.

The sheets are plated with copper in weights which correspond to thicknesses of 18, 9, or 5 micrometers. Such plating is commercially available from 3M Corporation, Austin, Texas.

The patterns of traces are produced by known photolithography techniques, giving a line width of less than 0.002 inches (0.051mm) and preferably 0.001 inches (0.025mm), with spacings of one (0.025mm) or two mils (0.051mm) between adjacent lines.

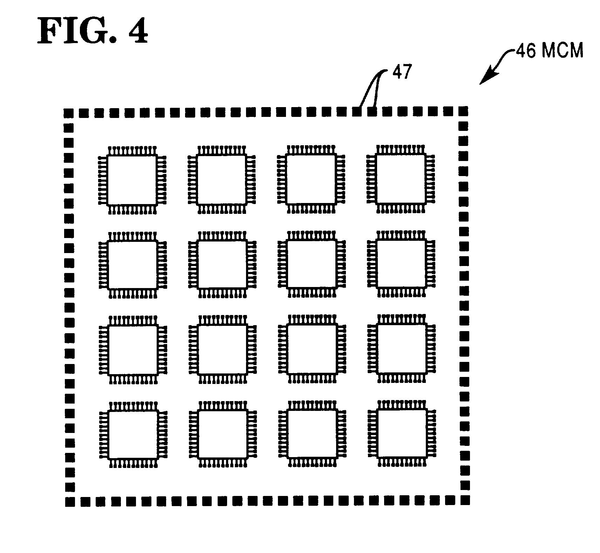

The Flexible Lamina stack 30 is attached to a conventional printed circuit board 38 by pins 39. The pins act as both mechanical connectors between the Flexible Lamina stack and the p.c.b. and also as electrical connectors between the pads 42 on the stack 30 and traces 43 on the p.c.b. Figs. 4 - 7 show greater detail of the inventive concept.

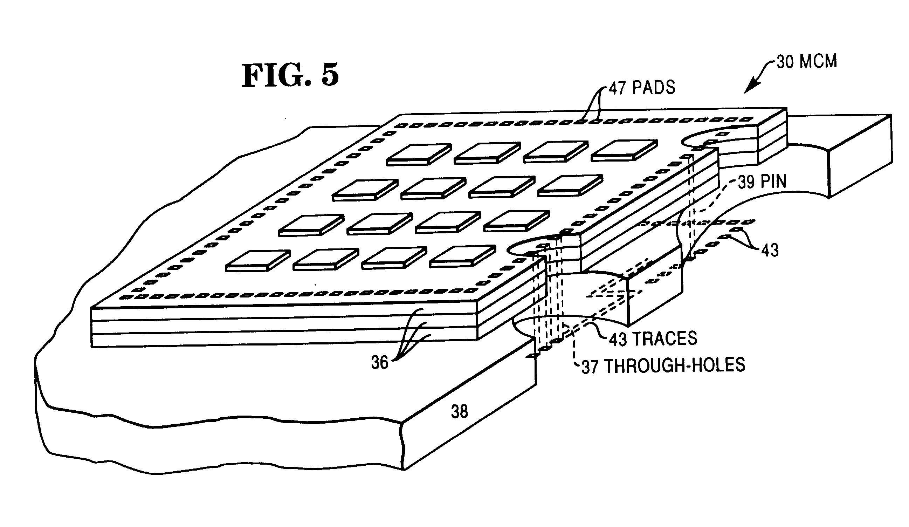

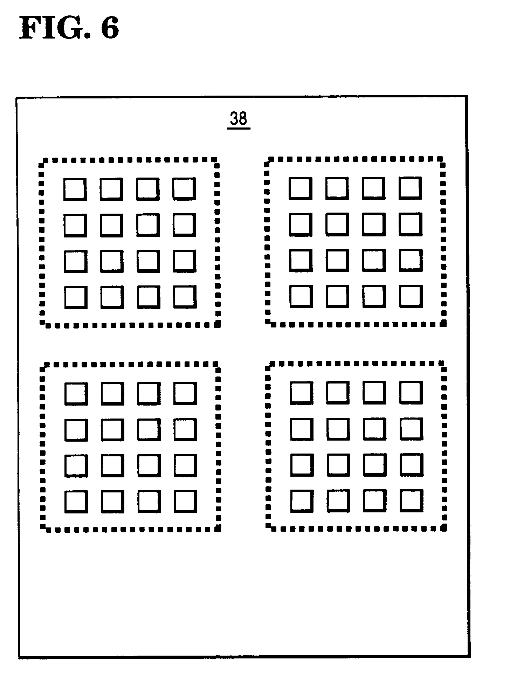

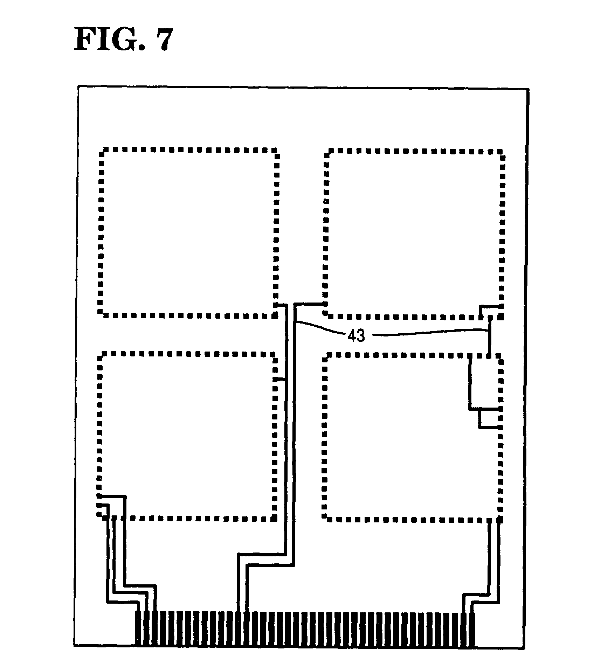

Fig. 4 shows a top view of a Flexible Lamina Stack 46 carrying ICs 33. Conductive pads 47 are provided on the upper surface. Fig. 5 shows one such Flexible Lamina stack mounted on a conventional p.c.b. 38. Holes 37 (not all shown) are drilled from each pad 47, through the stack and the p.c.b., to a respective trace 43. A pin 39, indicated by a dashed line, is inserted into the hole, and connects the pad with the trace. Fig. 6 shows a top view of a board carrying four Flexible Lamina stacks, and Fig. 7 shows a bottom view of the PC board, and a sample of the traces 43.

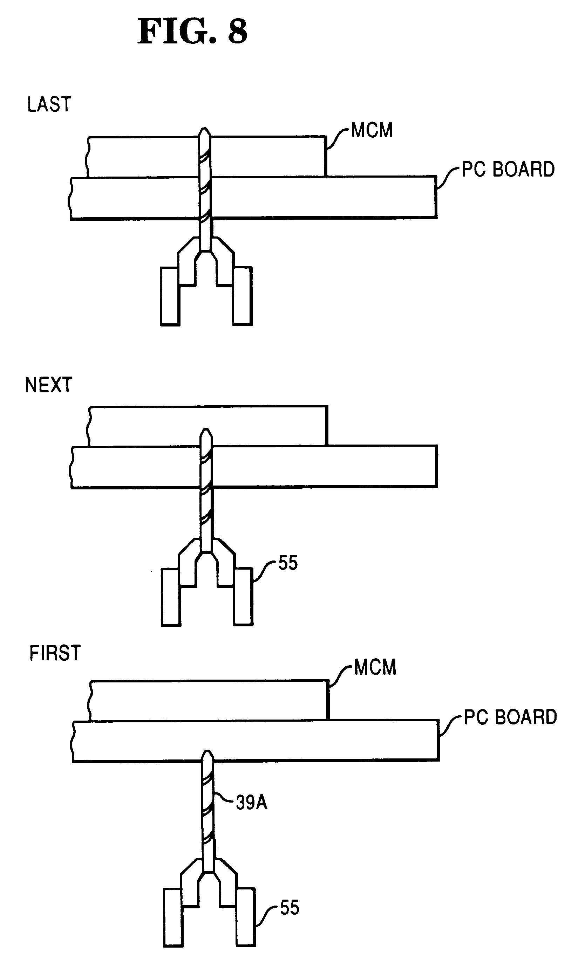

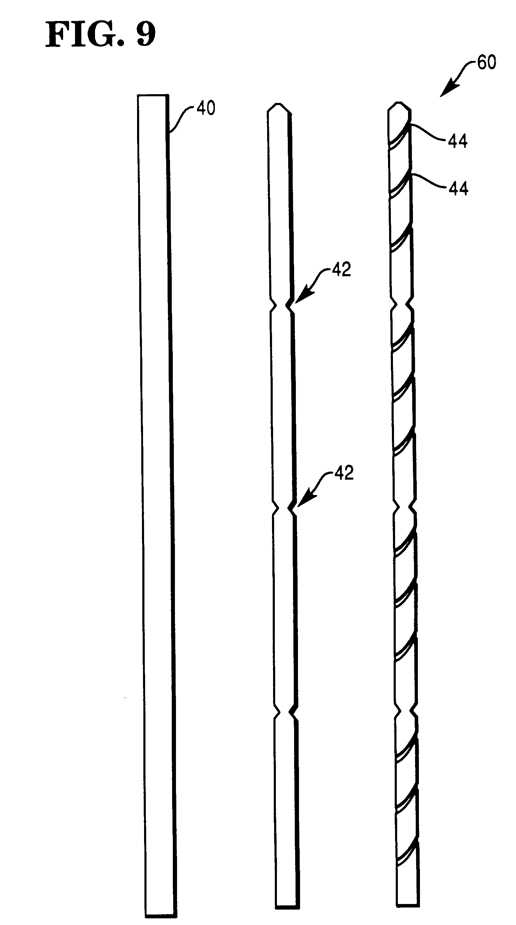

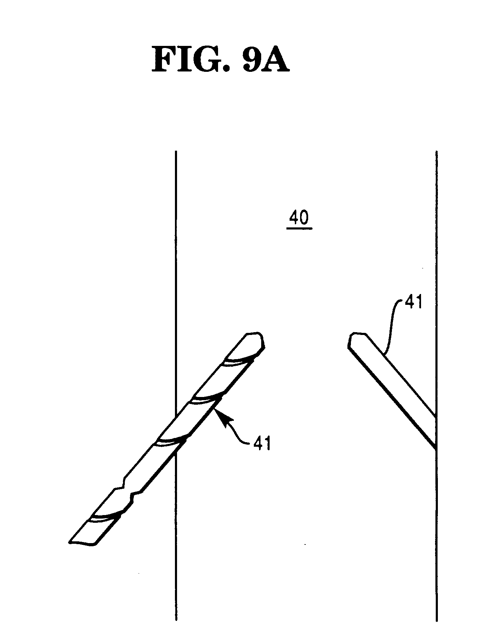

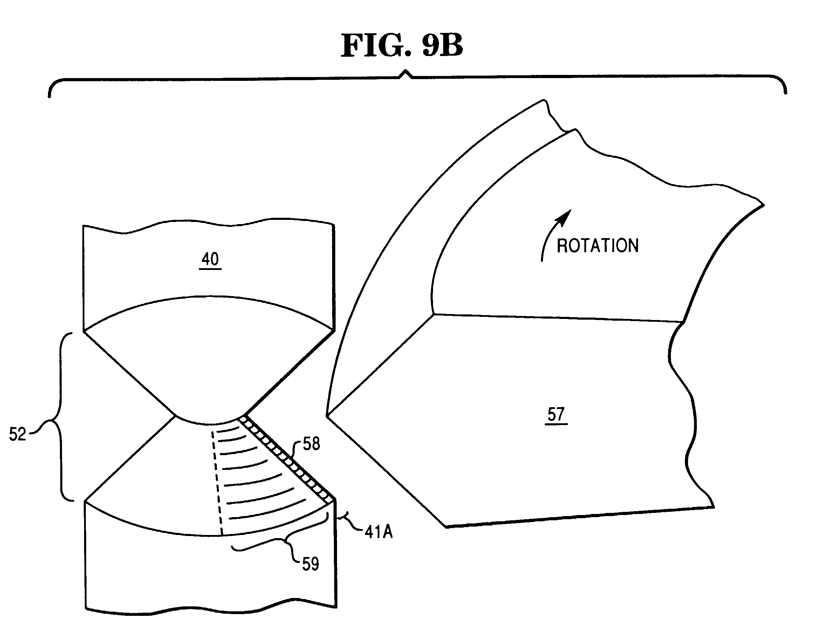

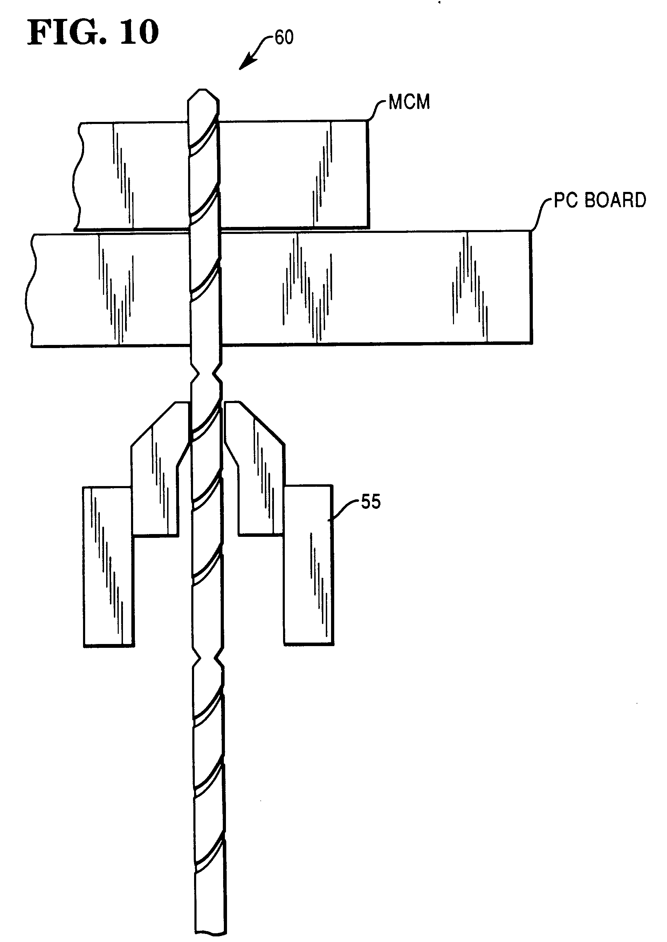

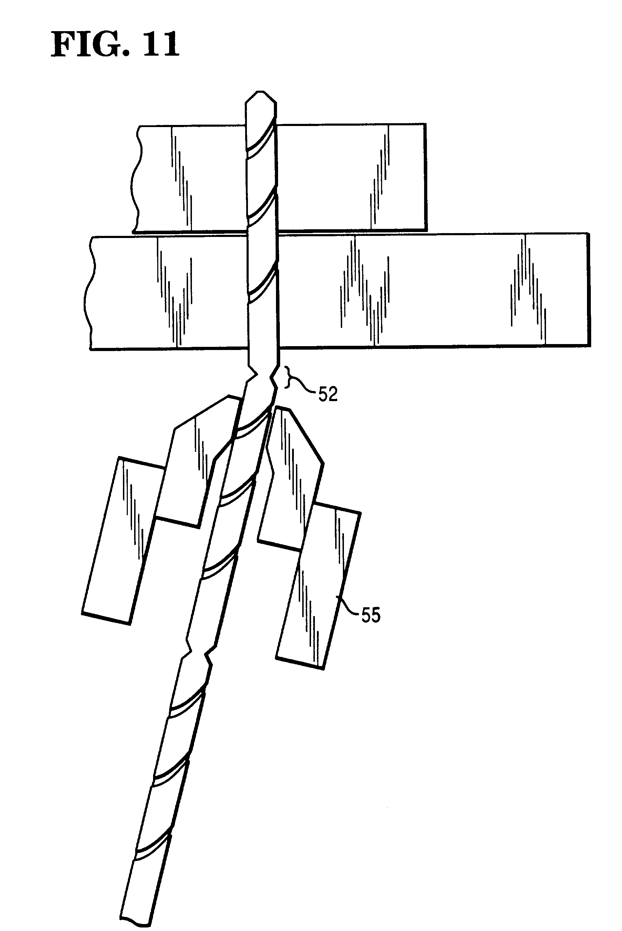

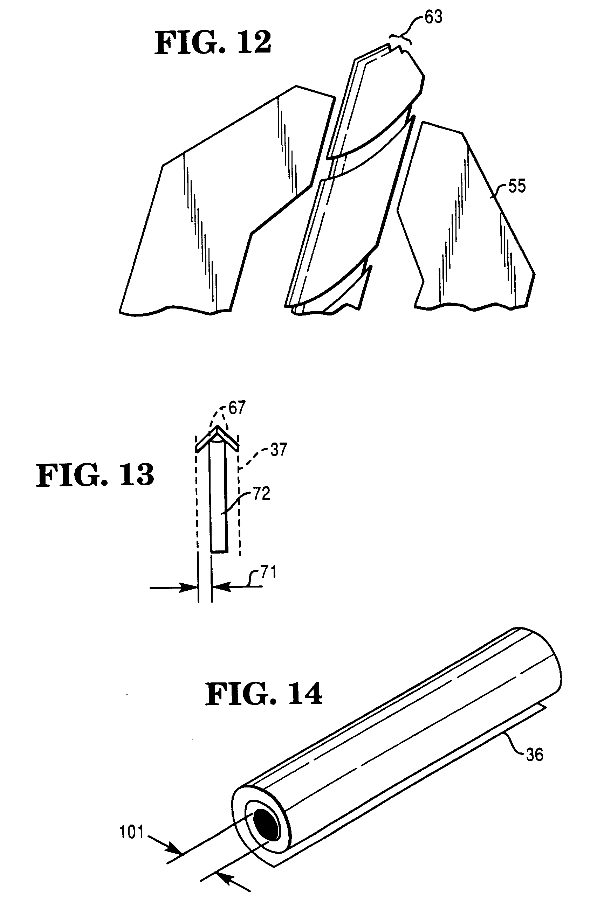

Several significant features of the invention are the following:
1. For the Flexible Lamina stacks, Mylar sheet is commercially available in rolls of standard widths, such as 40 inches (0.016m). The large size allows photolithographic printing of the conductive traces to be carried out over a larger area, exposing many conductive patterns in one operation, thus reducing cost. The inventor estimates that one layer of sheet, bearing a completed trace pattern, will cost about $ 1.00 per square inch (6.452 x 10⁻⁴m).
   The Flexible Lamina stack preferably uses three such sheets: two bearing patterns, such as patterns 15 and 18 in Fig. 2, and one bearing the pattern of vias 21.
2. One sheet can carry one type of pattern exclusively, or different patterns can be mixed on a given sheet. That is, for example, one sheet can carry exclusively the pattern 15 of vertical traces in Fig. 2, while another sheet can carry exclusively the pattern 18 of horizontal traces. This approach would require two photolithographic masters. Alternately, the two patterns can be printed on the same sheet, in the same step, and only a single master would be required.
3. The traces 43 in Figs 3 and 7, located on the printed circuit board, include power supply traces, as well as signal traces. Such power supply traces have a large cross-section, such as 0.1 inch x 18 micrometers (2.54mm x 18 micrometers), and thus provide a low-impedence connection.
4. The holes 37, or through-channels, in Fig. 5 need not be drilled prior to positioning of the Flexible Lamina stack adjacent the PC board. Instead, the lamina 36 can be stacked
   first, and the holes formed after stacking. Alternatively, the Flexible Lamina stack can be first positioned on the board, and the holes drilled afterward. The holes can range in diameter from about 0.39mm to 0.52mm.
   Programmable drilling machines which can repeatedly drill the patterns of holes are commercially available. In this connection, it is significant that the spacing between the pads is of the same order of magnitude as the spacing between the traces on the boards, namely, about 25 to 50 mils. Programmable drilling machines, as presently used in manufacturing printed circuit boards, can accurately drill 0.31mm to 0.52mm holes on 0.78mm to 1.56mm centres.
5. The type of pin 39 shown in Fig. 3 has a head, or flange, 40. After
   insertion, the head portion 40 of the pin 39 engages one of the Flexible Lamina stack or the board and the tail portion 49 forms a press-fit in an aperture in the other of the board or stack. Then the head and tail are soldered to their respective pads and traces.
   The head may be eliminated. Under this approach, an adhesive can attach the Flexible Lamina stack to the board, until soldering of the pins is completed.
6. The through-channels need not be pre-drilled prior to insertion of the pins. The pins themselves can act as drills, and can be soldered into position after drilling. Such pins are "sacrificial" in the sense that they perform a single drilling operation, and then are left in place, to act as conductors.
   For example, as shown in the sequence of Fig. 8, a chuck 55 holds the drill-pin 39A, and, starting with the position labelled "FIRST," drives it into the position labelled "LAST."
   As a modification to the drilling concept, the pins can be stacked and collectively form an integral drilling rod or wire 60 as in Fig. 9. There are numerous ways to manufacture such a stack of drill bits. For example, one can begin with the wire 40 in Fig. 9. Then, one drills two holes 41, as shown in Fig. 9A. Next, one grinds an annular notch 52, using the pointed grinding wheel 57 in Figure 11. The notch 52 is positioned such that part of the previously drilled hole 41 now forms a furrow 41A. The edge 58 of the furrow forms the cutting edge, or chisel edge of the drill. Shaded region 59 can be ground off, in order to effectively raise the cutting edge 58. Then, chip-clearance flutes 44 are formed, in a manner known in the art, as shown in drill stack 60 in Fig. 9.
   To use the stacked drill bits, a drill chuck 55 in Fig. 10 rotates the entire wire 60 and drills a pin into position, as shown. Then the wire 60 is snapped, as by bending the chuck 55 as shown in Fig. 11, to sever the inserted drill at the notch 52. (Other methods can be used to sever the pin: the chuck can rapidly accelerate or decelerate, or clippers (not shown) can sever the protruding part).
   If the method of severance leaves an asymmetric, jagged point 63 in Fig. 12, it is possible that the jagged point 63 will cause this bit to wander as it drills, and to drill a mislocated hole. This problem can be mitigated by using a centre punch (not shown) to dimple the board (or MCM) prior to starting of the drilling. The dimple acts as a crater which captures the jagged hole and prevents wandering.
   An alternative to chip-clearance flutes is the provision of chisel edges 67 in Fig. 13 which form a cutting diameter greater than the shank diameter. The difference 71 in diameters provides clearance for the chips and dust to escape from the hole. In effect, such a bit acts as a spade bit, with the clearance 71 acting as a flute, but with infinite pitch length.
7. Soldering is discussed above. It is recognized that different types of solder can be used, and that brazing or welding can be substituted for soldering.
8. As stated above, the copper-plated Mylar layers 36 in Figure 3 are supplied in long sheets and can be packaged in rolls. One such roll is shown in Fig. 14. The sheets are flexible, as indicated by the fact that they can be rolled around a radius 101 in Fig. 14 without damage. Radius 101 can be about 0.5 inches (12.7mm). However, when the layers 36 are stacked as shown in Fig. 3, the stack will become somewhat stiffer than the individual layers 36: the stack probably cannot be bent around the same radius 101 in Fig. 14 without damage. Thus, the layers are more flexible in their individual, separate states than when they are assembled into the stack. The layers can be described as "individually flexible," based on this characteristic.
9. The Flexible Lamina stack can be viewed as a multilayer printed circuit board, but with two primary differences. One, the line width is smaller, because the Flexible Lamina stack uses photolithographic printing techniques for masking and etching. In contrast, PC boards customarily use silk-screen printing processes, which produce larger line widths. Two, the Flexible Lamina stack uses flexible substrates 36 in Figure 3. Printed circuit boards generally use rigid substrates, such as glass-filled epoxy.
10. The term "Multi-Chip Module," or MCM, has been used. An MCM resembles a printed circuit board, but with a 3-dimensional network interconnecting the ICs, instead of a planar network, as in a standard board. The 3-dimensional network is formed by stacking individual boards, and interconnecting them, although other definitions of MCMs are available.

## Claims

1. Multilayer carrier for mounting an integrated circuit comprising a rigid printed circuit board (38), a multilayer structure (30) mounted on said board (38) and having a three dimensional network for electrical connection of at least one integrated circuit (33) to be mounted on said structure (30), and electrical connection means (39,40,49) for connecting electrical connection traces (43) on said board (38) to said network, said structure (30) comprising a plurality of flexible sheets (36) and said electrical connection means (39, 40, 42, 49) consists of a plurality of pin members (39) passing through said plurality of flexible sheets (36), characterized in that said traces (43) are located on a first side of said board (38) only, said structure (30) is mounted on a second side of said board (38) opposite said first side, and said pin members (39) pass through said board (38).

2. Carrier according to claim 1, characterized in that each of said pin members (39) has a head portion (40) for engaging one of said structure (30) or said board (38), and a tail portion (49) forming a press-fit in an aperture formed in the other of said structure (30) or said board (38) to provide for the mounting of said structure (30) on said board (38).

3. Carrier according to claim 1, characterized in that said pin members (39) are secured to said board (38) and said structure (30) by adhesive means.

4. Carrier according to any one of the preceding claims, characterized in that said pin members (39) are soldered to said traces (43) and said network.

5. Carrier according to claim 4, characterized in that said pin members (39) comprise drill bit members (60).

6. A method of forming a multilayer carrier for mounting an integrated circuit in which a multilayer structure (30) comprising a plurality of flexible sheets (36), with a three-dimensional network for electrical connection of at least one integrated circuit to be mounted on said structure (30), is mounted on a rigid printed circuit board (38) having electrical connection traces (43) so as to connect said network to said traces (43), characterized in that said traces are located on a first side of said board (38) only, and, said structure (30) is mounted on a second side of said board (38) opposite said first side, wherein the connection between said network and said traces (43) is formed by passing a plurality of conductive pin members (39) into said board (38) and said structure (30) so as to extend therethrough.

7. A method according to claim 6, characterized in that said structure (30) is mounted on said board (38) by forming a press-fit between said pin members (39) and apertures in said structure (30) for receiving said pin members (39).

8. A method according to claim 6 characterized in that said pin members (39) comprise drill bit members (60) which are drilled into said board (38) and said structure (30) so as to be located therein.

## Patentansprüche

1. Mehrschichtiger Träger zum Befestigen einer integrierten Schaltung, mit einer starren gedruckten Leiterplatine (38), einem mehrschichtigen Aufbau (30), der auf der Platine (38) befestigt ist und ein dreidimensionales Netzwerk zum elektrischen Anschluß mindestens einer auf dem Aufbau (30) zu montierenden integrierten Schaltung (33) besitzt, und einer elektrischen Verbindungsvorrichtung (39, 40, 49) zum Anschließen elektrischer Verbindungsleiterbahnen (43) auf der Platine (38) an das Netzwerk, wobei der Aufbau (30) eine Vielzahl biegsamer Platten (36) umfaßt, und die elektrische Verbindungsvorrichtung (39, 40, 42, 49) besteht aus einer Vielzahl von Stiftelementen (39), die durch die Vielzahl biegsamer Platten (36) hindurchgehen, dadurch gekennzeichnet, daß
die Leiterbahnen (43) nur auf einer ersten Seite der Platine (38) angeordnet sind, der Aufbau (30) auf einer zweiten Seite der Platine (38) entgegengesetzt zur ersten Seite montiert ist, und die Stiftelemente (39) durch die Platine (38) hindurchgehen.

2. Träger nach Anspruch 1, dadurch gekennzeichnet, daß jedes der Stiftelemente (39) einen Kopfabschnitt (40) aufweist, um entweder an dem Aufbau (30) oder der Platine (38) anzugreifen, und einen Endabschnitt (49) aufweist, der in Paßsitz in einen Ausschnitt eingesetzt ist, der entweder in dem Aufbau (30) oder der Platine (38) ausgebildet ist, um die Befestigung des Aufbaus (30) auf der Platine (38) vorzunehmen.

3. Träger nach Anspruch 1, dadurch gekennzeichnet, daß die Stiftelemente (39) durch Klebemittel an der Platine (38) und dem Aufbau (30) befestigt sind.

4. Träger nach einem der vorhergehenden Ansprüche, dadurch gekennzeichnet, daß die Stiftelemente (39) an die Leiterbahnen (43) und das Netzwerk angelötet sind.

5. Träger nach Anspruch 4, dadurch gekennzeichnet, daß die Stiftelemente (39) Drillbohrelemente (60) enthalten.

6. Verfahren zur Bildung eines mehrschichtigen Trägers zur Montage einer integrierten Schaltung, wobei ein mehrschichtiger Aufbau (30), bestehend aus einer Vielzahl von biegsamen Platten (36), mit einem dreidimensionalen Netzwerk zum elektrischen Anschluß von mindestens einer auf dem Aufbau (30) zu montierenden integrierten Schaltung auf einer starren gedruckten Leiterplatine (38) befestigt wird, die elektrische Verbindungsleiterbahnen (43) aufweist, um das Netzwerk an die Leiterbahnen (43) anzuschließen, dadurch gekennzeichnet, daß
die Leiterbahnen nur auf einer ersten Seite der Platine (38) angeordnet werden, und der Aufbau (30) auf einer zweiten Seite der Platine (38) entgegengesetzt zur ersten Seite montiert wird, wobei die Verbindung zwischen dem Netzwerk und den Leiterbahnen (43) dadurch gebildet wird, daß eine Vielzahl leitfähiger Stiftelemente (39) in die Platine (38) und den Aufbau (30) eingeführt wird, um sich durch diese hindurch zu erstrecken.

7. Verfahren nach Anspruch 6, dadurch gekennzeichnet, daß der Aufbau (30) durch Ausbildung eines Paßsitzes zwischen den Stiftelementen (39) und Ausschnitten zur Aufnahme der Stiftelemente (39) in dem Aufbau (30) auf der Platine (38) befestigt wird.

8. Verfahren nach Anspruch 6, dadurch gekennzeichnet, daß die Stiftelemente (39) Drillbohrelemente (60) enthalten, die in die Platine (38) und den Aufbau (30) zur Aufnahme darin eingebohrt werden.

## Revendications

1. Un support en plusieurs couches pour le montage d'un circuit intégré comprenant une carte à circuits imprimés rigide (38), une structure en plusieurs couches (30) montée sur ladite carte (38) et ayant un réseau tridimensionnel pour la connexion électrique d'au moins un circuit intégré (33) à monter sur ladite structure (30), et un moyen de connexion électrique (39, 40, 49) pour connecter lesdites traces de connexion électrique (43) situées sur ladite carte (38) audit réseau, ladite structure (30) comprenant une pluralité de feuilles flexibles (36) et ledit moyen de connexion électrique (39, 40, 42, 49) se compose d'une pluralité d'éléments fiches (39) traversant ladite pluralité de feuilles flexibles (36), caractérisé en ce que lesdites traces (43) sont situées d'un premier côté de ladite carte (38) seulement, ladite structure (30) est montée d'un deuxième côté de ladite carte (38) en face dudit premier côté, et lesdits éléments fiches (39) traversent ladite carte (38).

2. Un support conformément à la revendication 1, caractérisé en ce que chacun desdits éléments fiches (39) a une partie tête (40) pour engager soit ladite structure (30) soit ladite carte (38), et une partie queue (49) formant un va pressé dans une ouverture formée dans l'autre de ladite structure (30) ou de ladite carte (38) pour permettre le montage de ladite structure (30) sur ladite carte (38).

3. Un support conformément à la revendication 1, caractérisé en ce que lesdits éléments fiches (39) sont fixés à ladite carte (38) et à ladite structure (30) par un moyen adhésif.

4. Un support conformément à l'une quelconque des revendications précédentes, caractérisé en ce que lesdits éléments fiches (39) sont soudés auxdites traces (43) et audit réseau.

5. Un support conformément à la revendication 4, caractérisé en ce que lesdits éléments fiches (39) comprennent des éléments forets (60).

6. Une méthode pour former un support en plusieurs couches pour le montage d'un circuit intégré dans lequel une structure en plusieurs couches (30) comprenant une pluralité de feuilles flexibles (36), avec un réseau tridimensionnel pour la connexion électrique d'au moins un circuit intégré à monter sur ladite structure (30), est montée sur une carte à circuits imprimés rigide (38) ayant des traces de connexion électrique (43) de façon à connecter ledit réseau auxdites traces (43), caractérisée en ce que lesdites traces (43) sont situées d'un premier côté de ladite carte (38) seulement, et en ce que ladite structure (30) est montée d'un deuxième côté de ladite carte (38) en face dudit premier côté, dans quoi la connexion entre ledit réseau et lesdites traces (43) est formée en faisant passer une pluralité d'éléments fiches conducteurs (39) dans ladite carte (38) et dans ladite structure (30) de façon à ce qu'ils traversent ces dernières.

7. Une méthode conformément à la revendication 6, caractérisée en ce que ladite structure (30) est montée sur ladite carte (38) en formant un va pressé entre lesdits éléments fiches (39) et les ouvertures dans ladite structure (30) pour recevoir lesdits éléments fiches (39).

8. Une méthode conformément à la revendication 6, caractérisée en ce que lesdits éléments fiches (39) comprennent des éléments forets (60) qui sont percés dans ladite carte (38) et dans ladite structure (30) de façon à y être positionnés.
